# EUROPEAN PATENT APPLICATION

(11) **EP 4 557 321 A1**
(43) Date of publication of application: **21.05.2025**
(21) Application number: 23210182.4
(22) Date of filing: 15.11.2023
(51) Int. Cl.: H01C 3/20, H01C 7/22, H01C 1/14, H01C 3/12, H01C 3/10, G01R 15/04, H01C 17/065, H01C 1/148

(54) **RESISTOR STRUCTURE AND A VOLTAGE DIVIDER ARRANGEMENT**

(71) Applicant: ABB SCHWEIZ AG, 5400 Baden (CH)
(72) Inventor: HOZOI, Adrian, 68219 Mannheim (DE); SOMMER, Felix, 64285 Darmstadt (DE); MIGUNOV, Vadim, 68526 Ladenburg (DE); PODZEMNY, Jaromir, 621 00 Brno (CZ)
(74) Representative: Maiwald GmbH

(57) **Abstract**

The invention relates to a resistor structure comprising at least an electrically insulating substrate in a cylindrical form, at least one electrically conductive terminal directly or indirectly provided on the substrate, at least one resistive path directly or indirectly and at least partially provided on the substrate and directly or indirectly joined to the terminal, the resistive path running helically at least partially along the cylindrical form of the substrate and comprising at least one resistive trace,
characterized in that the geometry in connection with the resistive path is configured such that an intensity of the electrical field is at least in parts reduced.

## Description

### Field of the invention

The present invention concerns a resistor structure and a voltage divider arrangement as well as electric devices comprising such resistor structure and/or voltage divider arrangement.

### Background

Resistor structures and voltage divider arrangements are configured for high voltage applications, for example between 500 V and 1000 kV. Resistors which are employed at high voltages feature a high resistance to limit power dissipation, e.g. larger than 100 kΩ.

Resistor structures may comprise an electrically insulating substrate, at least one electrically conductive terminal applied on the substrate, and at least one resistive path applied on the substrate and joined to the terminal.

A voltage divider arrangement may, in its simplest embodiment, comprise two resistor structures electrically connected in series for transforming a high voltage, so-called primary voltage, to a lower voltage, so-called secondary voltage. The secondary voltage is significantly smaller than the primary voltage, e.g. by a voltage divider ratio between 10 to 100 000. In more complex embodiments of a voltage divider, one or both of the serial resistor structures may be replaced by resistive networks. The resistors or corresponding resistor networks may be referred to as high and low ohmic resistors, respectively.

These devices may be integrated in electrical devices, in which in particular severe operating conditions such as strong voltage overloads, power overloads, temperature variations, humidity variations, mechanical stresses and shocks may occur. Example electric devices are electronic instrument transformers (sensors), such as the KEVCD and KEVA sensor types of ABB, which are commonly employed in electrical power systems with a rated primary voltage between 7.2 kV and 48 kV.

US 9, 299, 484 B2, the contents of which is incorporated, discloses a resistive structure as well as a resistive voltage divider arrangement.

High voltage applications typically require particular engineering efforts, to ensure both functionality and safety. The reason is that such resistor structures are exposed to a high electric field intensity, typically imposing excessive electric stresses. This may result in dielectric failures, like partial discharge or electrical breakdown.

Therefore, it is desired to improve resistor structures and voltage divider arrangements as to manufacture, reliability and safety.

### Summary

The present invention is based on four aspects a to d, which can individually (independent of another aspect), in combination with one or more other aspects or altogether be realized and contribute individually and in combination to the solution.

The invention is directed to a resistor structure comprising at least an electrically insulating substrate in a cylindrical form, at least one, preferably two electrically conductive terminals directly or indirectly provided on the substrate, at least one resistive path (optionally in parts) directly or indirectly provided on the substrate and directly or indirectly joined to the terminal, the resistive path running helically at least partially along the cylindrical substrate and comprising at least one resistive trace, e.g. having a resistive trace tip (which may refer to the termination of the trace and may be flat or rounded or sharp) and/or forming a plurality of helical turns. The geometry in connection with the resistive path is configured such that an intensity of the electrical field is at least in parts reduced, and/or such that
(a) along at least a number of resistive traces, optionally any resistive trace of the resistive path, a slope of the resistive path relative to the circumferential direction does not exceed 15°, preferably 10°, more preferably 5°,
   and/or
(b) the at least one, optionally more than one resistive trace, optionally at an end of the resistive path directly or indirectly joined to the terminal, has an effective length which is shorter than the actual length of said resistive trace,
   and/or
(c) at an end of the resistive path, in the region where the resistive trace and the terminal are joined, an angle between the end of the resistive trace and the terminal is less than 15°, preferably less than 10°, more preferably less than 5°,
   and/or
(d) at an end of the at least one resistive trace, the tip of the resistive trace is rounded.

Accordingly, the present invention may help to reduce large differences of the intensity of the electrical field due to the geometry in connection with at least a part of the resistive path. Reducing the intensity of the electric field may lead to a reduction of electric stress. This helps to avoid dielectric failures, such as partial discharge or electrical breakdown.

More specifically, a levelling of the intensity of the electric field at least to some extent can be achieved. In other words, a gradient of the electrical potential may be decreased, so that a more uniform drop of the electrical potential may be obtained. In particular, discontinuities due to the resistive path may be reduced or avoided by way of a specific shape of parts of the resistive path and/or of entities connected to the resistive path, so that a more uniform intensity of the electric field can be obtained. It is conceivable that the intensity of the electrical field around the resistive path should substantially not differ more than 50%, preferably 30% along the resistive structure.

Controlling the effective resistive length e.g. by shunting sections achieves a smoother transition between the terminals and the resistive path. Often, there is an abrupt change of geometry and resistivity between the terminals and the resistive path. If the shunting sections modulate the resistance near the ends of the resistive path, the change of the effective resistive length may be seen as a resistance modulation. That is, a "mean value" of the resistance of the resistive path is gradually increasing from a terminal towards the middle of the resistive path. This may be a much more cost effective solution than using different materials having different resistivities (and also more accurate).

By adapting the geometry in connection with the resistive path, the run of the path itself, connections within the path or connections at the end of the path may be configured accordingly. For example, a smoother run of the resistive path may be obtained and/or a more seamless transition between a terminal and the resistive path may be supported. Abrupt terminations of the resistive trace at its tip may be avoided.

The intensity of the electric field is highest at interfaces between conductive/resistive entities and insulators. The effect / intensity is particularly severe at edges and sharp corners, because of accumulation of electric charges. The arrangement of the terminals and of the resistive path is improved to achieve a smooth / seamless distribution of the electric potential on the resistive structure and around the resistive structure (e.g. terminal - resistor path - terminal, terminal - insulator - terminal). There are local variations of the electric field intensity near the edges of the terminals and of the resistive path. A more "uniform distribution" shall be understood as "uniform local variations" or almost constant peaks of the local variations.

Accordingly, by means of the invention, the accuracy and the voltage withstand of the resistor structure and of the corresponding voltage divider arrangement may be enhanced.

Resistive materials commonly employed in thick film technology are based on formulations mainly comprising glass, particles of conductive oxide ceramic such as ruthenium oxide, and possibly other additives such as metal particles. Thick film resistive materials or films have a resistivity (sheet resistance) usually comprised between 50 mΩ/square and 1 GΩ/square.

In the context of the invention, a resistive trace of the resistive path is made of a resistive material with resistivity preferably between 50 Ω/square and 100 MΩ/square, or preferably between 500 Ω/square and 10 MΩ/square. Non-exhaustive examples of possible resistive materials are the R8700 Series from Heraeus or the 2000 Series from DuPont.

Electrically conductive materials commonly employed in thick film technology are based on formulations comprising a major amount of metal particles like Ag, Pd, Au, Pt and possibly other additives. Thick film conductor materials or films have a resistivity usually comprised between 1 mΩ/square and 1 Ω/square. Non-exhaustive examples of possible conductive materials are the C2210 from Heraeus or the 7484 from DuPont.

An insulator material is seen as having a volume resistivity larger than 10⁷ Ω·cm.

Optionally, the slope of the resistive path relative to adjacent regions of the resistive path along the run of the resistive path varies by less than 15°, preferably less than 5°. A uniform resistive path contributes to a uniform intensity of the electrical field.

Optionally, the mean slope of the at least one or all resistive traces comprised in the resistive path along its entire length is less than 3°, and preferably less than 2°. Such slope may allow for more uniformity along the path and for smoother connection to terminals at the end of the resistive path. For example, an advantage may be that an appropriate effective length of the resistive trace at the end of the resistive path, namely upon contact with the terminal, is achievable.

Optionally, a distance between regions of the resistive path distanced and subsequent to each other when viewed perpendicular to the run of the resistive path or in the direction connecting opposite terminals (i.e. in the longitudinal direction), where the said regions belong to at least a resistive trace, may vary less than 0.6 mm or preferably less than 0.2 mm and is optionally substantially constant. If the variation in distance between subsequent resistive traces is small in that almost no variations exist, a uniform and smooth intensity of the electric field may be supported. If the resistive path has one or more traces, the distance between turns of the resistive path may variy by around 40% to 100% in the region of the transition elements. These discontinuities have negligible impact on the peaks of the intensity of the electric field, especially when rounding the ends of resistive traces.

Optionally, substantially along the entire resistive path, said distance varies less than 50% or preferably 20% and is optionally substantially constant. If the distance varies only slightly or not along the entire resistive path, this may lead to an effective improvement.

Optionally, the pitch of the helix varies less than 50% or 20% and/or less than 1 mm or 0.2 mm and is optionally substantially constant. The pitch of the helical run of the resistive path along the cylindrical substrate, if constant or only with slight deviations, helps to avoid discontinuities.

Optionally, the pitch may be approximately equal to or larger than twice the distance between subsequent resistive traces.

Optionally, the radius of the end of at least one resistive trace is constant or decreases towards the tip of the resistive trace. If a resistive trace does not terminate abruptly, but gradually by way of a rounded or curved termination, discontinuities along the resistive path may be avoided. If the curvature is defined by a constant radius or by a radius which decreases towards the tip of the resistive trace, this may provide an appropriate termination. The radius at the converging part before the tip is substantially equal or larger than 1/2 of the full width of the remaining resistive trace. Preferably, the radius near the base of the tip is larger than the radius at the tip.

Optionally, the terminal comprises a shunt section which protrudes from the remaining terminal and connects to a portion of the resistive trace, the portion being distanced from the end of the resistive trace. The shunt section may help to adjust the effective length of the resistive trace, i.e. to shorten the real length of the resistive trace by providing a connection to the resistive trace not at the end of the resistive trace, but before the end of the resistive trace.

Optionally, the at least one shunt section represents an interconnecting element connecting at least two resistive traces in the direction perpendicular to the direction of the run of the resistive path or the direction from one end to the other end of the structure, optionally also with the terminal. A shunting section in the form of a connecting element may help to configure a voltage divider arrangement as regards the effective length of resistive traces.

Optionally, at least one resistive trace at the end of the resistive path comprises a connecting part projecting from the remaining resistive trace at least along a part of the length of the remaining resistive trace in the direction perpendicular to the direction of run of the resistive path. A connecting part may, accordingly, help to adjust the effective length of a resistive trace.

Optionally, the resistive path comprises a number of resistive traces and a number of transition elements connecting resistive traces to each other in the direction of the run of the resistive path. The resistive path may comprise resistive traces which are electrically connected in series by transition elements to form the resistive path. Resistive traces may, at least partially, run parallel to each other. This allows for an efficient manufacturing. Alternatively, the resistive path may consist of a single resistive trace which runs continuously from one terminal to the opposite terminal. A continuous helical turn may be regarded as single resistive trace, without transition elements.

Optionally, the at least one transition element represents an interconnecting path connecting at least two resistive traces of the resistive path along the direction of the run of the resistive path and the portion of the terminal. This represents a parallel connection of resistive traces. As such, the effective length of the resistive traces can be adapted.

Optionally, the resistive traces are arranged subsequently along the run of the resistive path, wherein the effective length of at least two subsequent resistive traces is decreased by connecting said at least two resistive traces by way of a transition element which is longer than at least one of the plurality of transition elements. By adapting the effective length of resistive traces, in particular at the end of the resistive path, by way of the length of the transition element used for connecting the resistive traces, positive effects as regards the electric field can be obtained.

Optionally, the effective length of at least subsequent resistive traces decreases towards the end of the resistive path, which end is joined to the terminal. This supports smoothness as regards the electrical field near the terminal.

Optionally, an interconnecting path connects at least one resistive trace of the resistive path and a terminal, where a part of the interconnecting path being joined to the at least one resistive trace of the resistive path is provided substantially along the direction of the resistive trace. This helps to reduce the electric field intensity and stress at the end of the first resistive path and at the interconnecting path.

Resistor structures of the invention may be manufactured using thick film technology, e.g. screen printing or stencil printing or direct printing through a nozzle. Films of conductive material and of resistive material are sequentially deposited on an insulating substrate. Typically, a single layer of a single material is deposited, followed by a subsequent step such as drying or firing. For example, conductive film or a resistive film are fired at a very high temperature, between 600°C and 950°C.

The insulating substrate may be made of ceramic material, such as aluminum oxide or aluminum nitride.

In addition to the first electrically conductive terminal, at least a second electrically conductive terminal may be typically provided in a resistive structure, wherein the resistive path connects to the first and second terminals. In a voltage divider, the high and low-ohmic resistors may share a terminal, so that a voltage divider arrangement may comprise at least first, second and third terminals.

A coating made of an electrically insulating material may be provided. In some embodiments, the coating may be the outermost entity or layer. The coating may cover the entire resistive structure or partially. The coating may cover at least part of the resistive path and possibly part(s) of the terminal(s). A part of each terminal is preferably not covered by the coating in order to provide electrical connection(s) to the resistive structure. The coating may be a film and may be made of a thickness between 5 to 100 µm and/or between 3 to 30 µm. The coating film may have different thicknesses, optionally a first thickness being between 5 and 100 µm, and a second thickness being between 3 and 30 µm, where the first thickness is larger than the second thickness by at least 50% or at least 5 µm.

Optionally, a second coating, e.g. made of a polymer, may be applied on a first coating. The second coating may be thicker than the first coating.

A shunt may be provided. A shunt section is configured to shunt a distinct portion of a resistive trace to proportionally reduce its effective resistive length. This may mean that the length which is electrically effective (and, thus, determines the electrical resistance of the trace) is shorter than the actual length of the trace. A transition element may act as shunt section. A shunt section has a lower resistivity than the resistive trace to which the shunt section (e.g. transition element) is connected to.

Optionally, the resistor structure comprises resistive traces being mainly identical and being preferably arranged periodically with mainly a same pitch. The resistive traces may be made of a same resistive material, and may have mainly a same thickness, width, slope, and (actual) length. This helps for efficient and reproducible manufacturing of the resistive traces and of the resistive path.

Optionally, the resistive path comprises a plurality of helical turns, and the resistance of a helical turn decreases at an end of the path such that a first helical turn at the end of the resistive path has a resistance which is smaller than the resistance of at least one of the plurality of helical turns of the resistive path by at least 15%, preferably by at least 30%.

Optionally, a second helical turn of the resistive path has a resistance which is smaller than the resistance of at least one of the plurality of helical turns of the resistive path by at least 10%, where the second helical turn is preferably subsequent to the first helical turn.

Optionally, at least a helical turn of the resistive path is provided with one or more resistive traces and with one or more transition elements and/or shunts having a resistivity smaller than the resistivity of the resistive trace(s) of the resistive path. That is, a helical turn may comprise a number of transition elements connecting a number of resitive traces. Or a helical turn may comprise a plurality of small shunts.

Optionally, two terminals are provided at the opposite side of the second resistive path with respect to the first resistive path. This may help to reduce the intensity of the electrical field at the terminals.

A voltage divider arrangement of the invention may comprise a high ohmic resistor and a low ohmic resistor electrically connected in series, where the voltage divider arrangement comprises at least one resistor structure of the invention. The high ohmic resistor is made of one or more resistive traces and the low ohmic resistor is made of one or more resistive traces, and the high ohmic and the low ohmic resistors differ as to their resistance.

Optionally, the voltage divider arrangement is provided on the same substrate and comprises resistive traces being substantially identical. This may provide an arrangement which is more effective to manufacture and more stable.

An electrical device of the invention comprises a resistor structure or a voltage divider arrangement of the invention.

### Brief description of the drawings

Figure 1 shows a resistor structure of the invention, wherein the figures 1(a) and (b) show perspective views from different angles.
Figure 2 schematically shows the connection between a resistive trace and a transition element, wherein figures 2(a) to (c) refer to different embodiments.
Figure 3 shows a voltage divider arrangement of the invention, wherein figures 3(a) and (b) show perspective views from different angles.
Figure 4 shows another voltage divider arrangement of the invention, wherein figures 4(a) and (b) show perspective views from different angles.
Figure 5 shows a voltage divider arrangement of the invention, wherein figures 5(a) and (b) show perspective views from different angles.

### Detailed description of embodiments

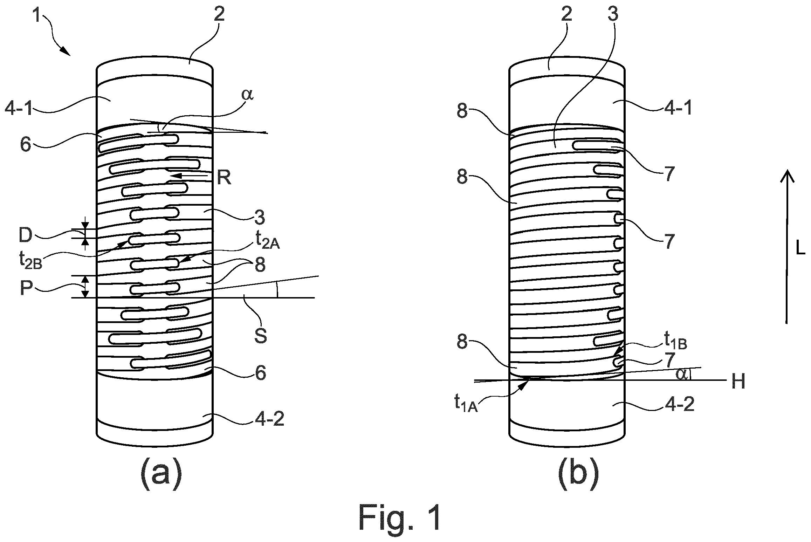

Figures 1(a) and (b) show an electrical resistor structure 1 of the invention, wherein the structure 1 comprises an electrically insulating substrate 2. The substrate 2 as shown is a cylinder. At least one electrically conductive terminal 4 is directly or indirectly provided on the substrate 2. In the embodiments shown in figures 1(a) and (b), two terminals 4 are provided, namely a first terminal 4-1 and a second terminal 4-2 at opposite ends of the resistor structure 1. A resistive path 3 is directly or indirectly provided on the substrate 2 and extends along a part of the substrate 2. The resistive path 3 is directly or indirectly joined to the terminals 4. In the embodiment shown in figures 1(a) and (b), the resistive path 3 is directly on the substrate 2 and directly joined to the first and second terminals 4-1, 4-2. The resistive path 3 runs helically along the cylinder formed by the substrate 2 from the first terminal 4-1 to the opposite second terminal 4-2 and comprises a plurality of resistive traces 8. Two resistive traces 8 are connected with each other by a transition element 7. The resistive path 3 is formed at least by a plurality of resistive traces 8 and a plurality of transition elements 7. Basically, due to the helical run of the resistive path 3, the resistive traces 8 run parallel to each other. The resistive path 3 extends in the direction R, which is the direction of the run of the resistive path 3, i.e. the helix.

According to the invention, the geometry in connection with the resistive path 3 is configured such that the intensity of the electric field is reduced at least in parts along the structure 1. As shown in figure 1(a), along any resistive trace 8 of the resistive path 3, a slope S of the resistive path 3 relative to the circumferential direction H (which is, in figure 1, a horizontal) does not exceed 15°, preferably 10°, more preferably 5°. The circumferential direction H extends perpendicular to a longitudinal direction L of the resitive structure 1 and touches a point of the surface of the substrate 2. This supports a uniform intensity of the electrical field between the ends of the resistive structure 1. According to the embodiment of figure 1, the slope S of the resistive path 3 relative to adjacent regions of the resistive path 3 along the run R of the resistive path 3 varies by less than 15°, preferably less than 5°. Rather, the slope S is substantially constant along the entire resistive path 3. The mean slope Sm of the resistive trace(s) 8 comprised in the resistive path 3 along its entire length is less than 3°. Figure 1(a) shows that the angle α between the end of the resistive trace 8 and the terminal 4 is less than 15°, preferably less than 10°, preferably less than 5°.

Figure 1(a) indicates a distance D between regions of resistive traces 8 of the resistive path 3 distanced and subsequent to each other when viewed from one end to the opposite end of the resistive structure 1. The distance D varies less than 0.2 to 0.6 mm and is, in the embodiment of figure 1, substantially constant. Along the entire resistive path 3, the distance D should vary less than 30%.

The helix formed by the resistive path 3 has a pitch P of about 0.3 to 3 mm and may vary less than 50% to 20% and/or less than 0.2 to 1 mm. In the embodiment shown in figure 1, the pitch P is constant.

Figure 1(b) shows a a point t_{1A} of the resistive trace 8 at which it connects to the terminal 4-2, where the point t_{1A} indicates a first effective ending of the resistive trace 8 and an effective ending of the resistive path 3. A point of the resistive trace 8 at which it connects to the transition element 7 is indicated as point t_{1B}. The latter indicates a second effective ending of the resistive trace 8, so that an effective length l1 of said resistive trace 8 is between the points t_{1A} and t_{1B}. The effective length l1 is shorter than the actual, real length of the resistive trace 8, as the resistive trace 8 also extends underneath the transition element 7 and, at the opposite end of the resistive trace 8, underneath the second terminal 4-2. Hence, the effective length l1 of said resistive trace 8 is shorter than its actual, real length. Also the effective length of the resistive trace 8 at the opposite end of the path 3 is effectively shortened where the resistive trace 8 connects to the first terminal 4-1.

Figure 1(a) shows various transition elements 7, the length and position of which relative to the resistive traces 8 differs. More specifically, in a central part of the resistive path 3, the effective length of a resistive trace 8 is longer, namely the trace 8 has an effective length l2 determined by the connections to the adjacent transition elements 7, i.e. running from point t_{2A} to point t_{2B} along the extension of the trace 8. When looking at resistive traces 8 arranged subsequently along the resistive path 3, the effective length of at least two resistive traces 8 is decreased by connecting said two resistive traces 8 by way of a transition element 7 which is longer than the preceding transition element 7. Figure 1(a) shows that the effective length of subsequent resistive traces 8 decreases from the middle of the resistive structure 1 towards the ends of the resistive path 3, which ends are joined to the terminal 4. In figure 1(a), four transition elements 7 having the same length in about the middle of the resistive path 3 are shown, wherein the length of the transition elements 7 gradually increases towards the ends of the resistive path 3, i.e. towards the terminals 4. Accordingly, the effective lengths of the resistive traces 8 are gradually shortened.

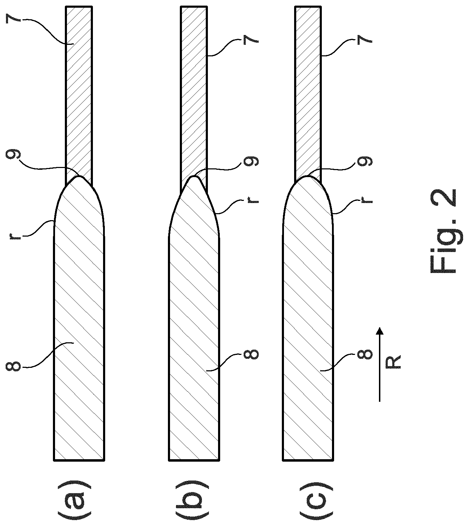

Figure 2 shows ends of a resistive trace 8 having a resistive trace tip 9. Joined to the resistive trace 8 is a transition element 7. Typically, the resistive trace tip 9 represents a 90°-termination of the resistive trace 8 relative to the extension of the resistive trace 8 in the direction R, which can be seen as an abrupt termination of the resistive trace 8. The invention is directed to a rounded termination of the resistive trace 8. This may be seen as a gradual reduction of the width of the resistive trace 8 towards the tip 9. The end of the resistive trace 8 can be seen as having a specific curvature. Put differently, the end of the resistive trace 8 is rounded and has a radius r. In figure 2(a), the radius decreases towards the tip 9 of the resistive trace. In figure 2(b), the tip 9 is rounded, wherein the end of the resistive trace 8 has inclined surfaces (e.g. lateral sides) converging toward the tip 9. In figure 2(c), the tip 9 is broader, wherein the radius r at the end of the resistive trace 8 is larger. For example, in the embodiment of Figure 1, the ends of the resistive traces 8 are rounded.

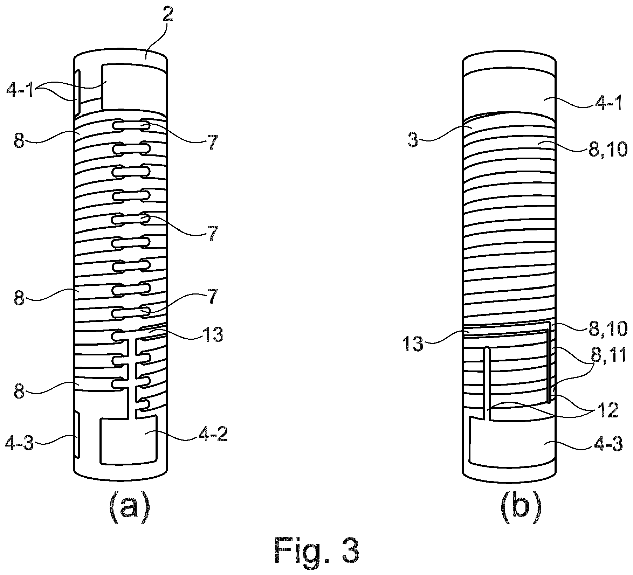

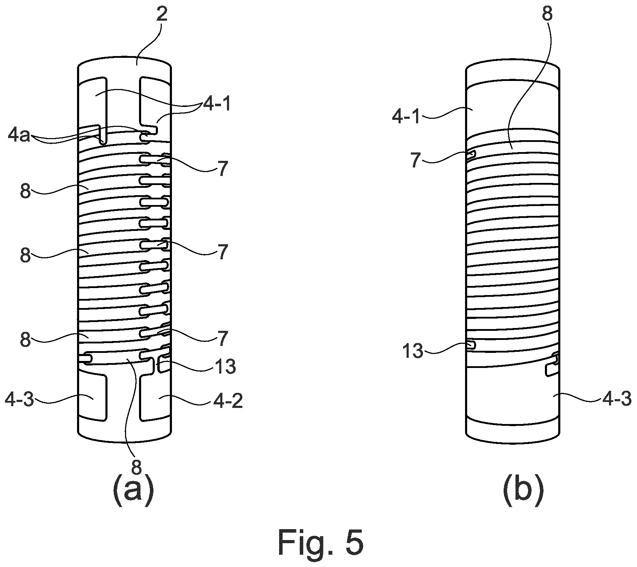

Figure 3 shows a voltage divider arrangement having a high ohmic resistor 10 and a low ohmic resistor 11. First 4-1, second 4-2 and third 4-3 terminals are provided, wherein the first terminal 4-1 is arranged at an end of the structure 1 opposite to the end where the second and third terminals 4-2, 4-3 are located. Various transition elements 7 for connecting the various resistive traces 8 are provided. Towards the end of the second 4-2 and third 4-3 terminals, a transition element 7 in the form of an interconnecting path 13 is provided and connects to the second terminal 4-2. The interconnecting path 13 connects at least two resistive traces 8, here four traces 8, and the second terminal 4-2, see figure 3(a). The structure 1 further comprises, as seen in figure 3(b), an interconnecting element 12 which connects at least two resistive traces 8 (or at least one resistive trace 8), here three resistive traces 8, in the direction perpendicular to the direction R as well as the third terminal 4-3. There are two interconnecting elements 12 connected to the terminal 4-3, but only one is visible. Three or more can be provided in other embodiments. The interconnecting element 12 may be seen as a shunt section, which is discussed below in connection with figure 5 in more detail. However, the interconnecting element 12 is not equivalent to the shunt in Figure 5. The interconnecting elements 12 and the interconnecting path achieve a parallel connection of the trace parts 8 they are connected to.

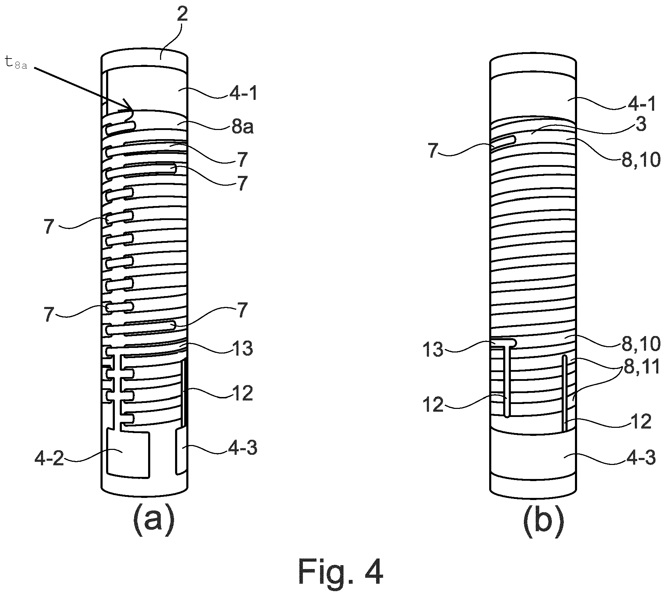

Figure 4 shows a voltage divider arrangement 5 similar to the arrangement shown in figure 3. Additionally, in the embodiment of figure 4, the resistive trace at the end of the resistive path 3 at the terminal 4-1 comprises a connecting part 8a projecting from the remaining resistive trace 8 at least along a part of the length of the remaining resistive trace in the direction perpendicular to the direction R of the run of the resistive path 3. As such, the effective length of the resistive trace 8 at the terminal 4-1 is shortened as the position of the "first" contact between the resistive trace 8 and the terminal 4-1 has been shifted by way of the connecting part 8a to a postion t₈ₐ. Hence, the connecting part 8a may be seen as to reduce the effective length of the resistive trace 8.

Figure 5 shows a voltage divider arrangement 5 similar to the arrangement shown in figure 3. Additionally, in the embodiment of figure 5, a terminal is specifically configured. More specifically, the terminal 4-1 comprises a shunt section 4a which protrudes from the remaining terminal 4-1 and connects to a portion of the resistive trace 8 which is connected to the terminal 4-1, wherein the portion is distanced from the end of the resistive trace 8. For example, the shunt section 4a protrudes from the remaining terminal 4-1 in the direction of the opposite terminal(s) 4-2, 4-3. The terminal 4-1 is provided with two shunting sections 4a and the shunt path is through a first shunting section 4a , the terminal 4-1, and the second shunting section 4a. The part of the trace 8 between the shunting sections 4a is shunted.

### Reference signs

1 resistor/resistive structure
2 electrically insulating substrate
3 resistive path
4 terminal
4a shunt section
4-1 first terminal
4-2 second terminal
4-3 third terminal
5 voltage divider arrangement
7 transition element
8 resistive trace
8a connecting part
9 resistive trace tip
10 high-ohmic resistor
11 low-ohmic resistor
12 interconnecting element
13 interconnecting path
S slope of resistive path
α angle between terminal and resistive trace/path
I effective length of trace
t_{A}, t_{B} beginning and end of trace
H horizontal/circumferential direction
L longitudinal direction
R direction of run of resistive path
D distance
P pitch of helix
r radius

## Claims

1. Resistor structure (1) comprising at least
an electrically insulating substrate (2) in a cylindrical form,
at least one electrically conductive terminal (4) directly or indirectly provided on the substrate (2),
at least one resistive path (3) directly or indirectly and at least partially provided on the substrate (2) and directly or indirectly joined to the terminal, the resistive path (3) running helically at least partially along the cylindrical form of the substrate and comprising a plurality of helical turns and at least one resistive trace (8),
**characterized in that**
the geometry in connection with the resistive path (3) is configured such that an intensity of the electrical field is at least in parts reduced, in particular such that
(a) along any resistive trace of the resistive path (3), a slope (S) of the resistive path (3) relative to the circumferential direction of the cylindrical substrate (2) does not exceed 15°, preferably 10°, more preferably 5°,
and/or
(b) the at least one resistive trace (8), optionally at an end of the resistive path (3) joined to the terminal (4) or optionally a plurality of resistive traces (8), has an effective length which is shorter than the actual length of the resistive trace (8),
and/or
(c) at an end of the resistive path (3), in the region where the resistive trace (8) and the terminal (4) are joined, an angle (α) between the end of the resistive trace and the terminal (4) is less than 15°, preferably less than 10°, more preferably less than 5°,
and/or
(d) at an end of the at least one resistive trace (8), a resistive trace tip (9) is provided, and the tip (9) of the resistive trace (8) is rounded.

2. Resistor structure of claim 1, wherein, according to (b), the resistive path (3) comprises a plurality of helical turns, and the resistance of a helical turn decreases at an end of the path (3) such that a first helical turn at the end of the resistive path has a resistance which is smaller than the resistance of at least one of the plurality of helical turns of the resistive path by at least 15%, preferably by at least 30%.

3. Resistor structure of claim 1 or 2, wherein, according to (a), a mean slope (Stm) of the at least one or all resistive traces (8) comprised in the resistive path (3) along its entire length is less than 3°, and preferably less than 2°.

4. Resistor structure of any of the preceding claims, wherein, according to (a), a distance (D) between regions of the resistive path (3) distanced and subsequent to each other when viewed perpendicular to the run of the resistive path (3), where the said regions belong to at least a resistive trace (8), varies less than 50%, preferably less than 20% and/or is substantially constant.

5. Resistor structure of claim 4, wherein, according to (a) and (c), substantially along the entire resistive path (3), the distance (D) varies less than 30% and is optionally substantially constant.

6. Resistor structure of any of the preceding claims, wherein, according to (b), a second helical turn of the resistive path (3) has a resistance which is smaller than the resistance of at least one of the plurality of helical turns of the resistive path by at least 10%, where the second helical turn is preferably subsequent to the first helical turn.

7. Resistor structure of any of the preceding claims, wherein, according to (d), the radius (r) of the end of at least one resistive trace (8) is constant or decreases towards the tip (9) of the resistive trace (8).

8. Resistor structure of any of the preceding claims, wherein, according to (b), at least a helical turn of the resistive path (3) is provided with one or more resistive traces (8) and with one or more transition elements and/or shunts having a resistivity smaller than the resistivity of the resistive trace(s) (8) of the resistive path (3).

9. Resistor structure of claim 8, wherein the at least one shunt section represents an interconnecting element (12) connecting at least two resistive traces (8) in the direction perpendicular to the direction (R) of the run of the resistive path (3), optionally also with the terminal (4-3).

10. Resistor structure of any of the preceding claims, wherein terminals (4-2) and (4-3) are provided at the opposite side of a second resistive path with respect to a first resistive path.

11. Resistor structure of any of the preceding claims, wherein the resistive path comprises a plurality of resistive traces (8) and a number of transition elements (7) connecting resistive traces (8) to each other in the direction (R) of the run of the resistive path.

12. Resistor structure of claim 11, wherein at least one transition element (7) represents an interconnecting path (13) connecting at least two resistive traces (8) of the resistive path (3) along the direction (R) of the run of the resistive path and the portion of the terminal (4-2).

13. Resistor structure of claim 11 or 12, wherein, according to (b), the resistive traces (8) are arranged subsequently along the run of the resistive path (3), wherein the effective length of at least a resistive trace (8) is decreased by connecting said at least two resistive traces (8) by way of a transition element (7) which is longer than at least one of the plurality of transition elements (7), by at least 20% or preferably by at least 50%, more preferably by at least 100%.

14. Resistor structure of any of the preceding claims 11 to 13, wherein, according to (b), the effective length of at subsequent resistive traces (8) decreases towards the end of the resistive path (3), which end is joined to the terminal (4).

15. Voltage divider arrangement (5) for electrical power systems for transformation of voltage, the voltage divider arrangement comprising a first resistor structure (1) of any of the preceding claims, and a second resistor structure (1), optionally of any of the preceding claims, wherein the first and second resistor structures are connected in series and the first and second resistor structures differs as to their resistance.

16. Electrical device comprising the resistor structure (1) and/or voltage divider arrangement (5) of any of the preceding claims.
